# EUROPEAN PATENT SPECIFICATION

(11) **EP 4 679 715 B1**
(45) Date of publication and mention of the grant of the patent: **09.09.2026**
(21) Application number: 24188143.2
(22) Date of filing: 11.07.2024
(51) Int. Cl.: H03K 17/16, H02M 1/00, H02M 1/08

(54) **GATE DRIVING CIRCUIT FOR A POWER DEVICE**
GATE-TREIBERSCHALTUNG FÜR EINE LEISTUNGSVORRICHTUNG
CIRCUIT D'ATTAQUE DE GRILLE POUR UN DISPOSITIF DE PUISSANCE

(43) Date of publication of application: 14.01.2026
(73) Proprietor: Volvo Car Corporation, 405 31 Göteborg (SE)
(72) Inventor: ZHANG, Chi, 40531 Göteborg (SE)
(74) Representative: Kransell & Wennborg KB

(56) References cited:
- EP-A1- 3 654 533
- US-B1- 8 710 810
- US-B2- 10 528 071
- US-B2- 8 810 293

## Description

### TECHNICAL FIELD

The present disclosure relates to a gate driving circuit for a power device.

Moreover, the present disclosure is directed to a method for controlling a gate driving circuit for a power device.

### BACKGROUND ART

Power semiconductors, which acts as the key element of inverters, are playing a critical role regarding the performance of electrical vehicles. 3rd generation of power semiconductors (wide band gap device, WBG,) offer not only high voltage rating but also faster switching speed. So typically, WBG devices can switch from several kHz up to hundreds of kHz. Such a high speed will result in quite high switching loss as well as high drain-source-voltage switching off peak. Gate drivers for WBG devices, such as Silicone Carbide, SiC, devices, use a similar topology as insulated-gate bipolar transistors, IGBTs, in which typical push-pull circuits are used. In order to reduced drain-source-voltage peak during switching off, gate resistors with higher resistance will be used. However, this will bring even more switching loss to SiC devices.

Thus, there is a need for an improved gate driving circuit for a power device.

US 8 810 293 B2 relates to a pulsed gate driver.

US 10 528 071 B2 relates to an electronic drive circuit.

### SUMMARY

It is an objective of the present disclosure to provide an improved gate driving circuit for a power device.

The problem is at least partially solved or alleviated by the subject matter of the independent claims of the present disclosure, wherein further examples are incorporated in the dependent claims.

According to a first aspect, there is provided a gate driving circuit for a power device, comprising an interleaved buck converter circuit, being connected to a gate of the power device to drive the gate, a pulse width modulation, PWM, control unit, being connected to the interleaved buck converter circuit and at least one feedback detection circuit, being connected between the power device and the PWM control unit and being configured for providing feedback information of the power device to the PWM control unit. The PWM control unit is configured for modulating the interleaved buck converter circuit based on the feedback information to control a gate voltage or a gate current of the power device.

In other words, the gate driving circuit utilizes an interleaved buck converter circuit as gate driver to modulate the gate voltage or the gate current of power device, in particular during switching on and off processes of the power device. Thus, the PWM control unit is configured for modulating the interleaved buck converter circuit to control the gate voltage or the gate current in a PWM structure. In other words, instead of just setting the gate voltage to a negative supply voltage in the case of shutdown of the power device, the gate voltage at least partly has a PWM structure, in which the gate voltage changes between the negative supply voltage and the positive supply voltage. Consequently, instead of just setting the gate voltage to a positive supply voltage in the case of startup of the power device, the gate voltage at least partly has a PWM structure, in which the gate voltage changes between the positive supply voltage and the negative supply voltage. Preferably, the negative supply voltage is grounded.

The term "interleaved buck converter circuit", as used herein, comprises a plurality of push-pull circuits, wherein the plurality of push-pull circuits is connected in parallel to each other. By turning on and off of different push-pull circuits in different time sequences, the gate voltage or the gate current of the power device can be modulated in a more precise way. This allows balancing the drain-source-voltage switching off peak and switching off loss or the drain-source-current switching on peak and switching on losses. Also, the more push-pull circuits the interleaved buck converter circuit comprises, the better performance it can achieve. For example, the interleaved buck converter circuit is implemented by a gate driver integrated circuit with for example 256 push-pull circuits. By creating a proper gate loop PCB layout, the interleaved solution of the interleaved buck converter circuit offers faster dynamics regarding gate current or voltage control.

Pulse width modulation, PWM, is a type of digital modulation in which a technical variable (e.g. an electrical voltage) changes between two values, in particular a positive supply voltage and a negative supply voltage. A rectangular pulse is generated, or inother words modulated, at a constant frequency, the width or length of which varies. The ratio between pulse and period duration is referred to as duty cycle.

Preferably, the PWM control circuit is configured for providing a PWM signal for modulating the interleaved buck converter circuit based on the feedback information to control a gate voltage or a gate current.

Preferably, controlling the gate voltage is referred to as voltage control mode.

Preferably, controlling the gate current is referred to as current control mode.

Preferably, the PWM control unit comprises a digital controller (e.g. a field programmable gate array or a complex programmable logic device) with a high bandwidth. Alternatively, the PWMN control unit comprises a purely analog control (e.g. operational amplifier). In other words, through modulating the duty cycle of the interleaved buck converter circuit, either the output voltage (i.e. gate voltage) or output current (i.e. gate current) can be controlled with the help of high bandwidth of digital controller or purely analog control.

Preferably, during switching off, also referred to as shutdown, of the power device, the gate driving circuit is configured to suppress a peak in drain-source-voltage by modulating the interleaved buck converter circuit.

Preferably, during switching on, also referred to as startup, of the power device, the gate driving circuit is configured to suppress a peak in drain-source-current by modulating the interleaved buck converter circuit.

Preferably, the at least one feedback detection circuit comprises a power device voltage detection circuit providing the PWM control unit with a drain-source-voltage of the power device and/or a voltage change rate of the drain-source-voltage of the power device. Further preferably, the at least one feedback detection circuit comprises a feedback resistor circuit providing the PWM control unit with a measured gate current of the power device. Further preferably, the at least one feedback detection circuit comprises a power device current detection circuit providing the PWM control unit with a drain-source-current of the power device and/or a current change rate of the drain-source-current of the power device.

Thus, the gate driving circuit allows modulating in particular a duty cycle of the interleaved buck converter circuit by the PWM control unit, to either control the output voltage or output current of the interleaved buck converter circuit.

Consequently, the gate driving circuit provides an improved control of a change rate of the drain-source-voltage of the power device and a change rate of the drain-source-current of the power device.

Consequently, a peak in drain-source-voltage during shutdown of the power device and a peak in drain-source-current during startup of the power device can be reduced.

Thus, the gate driving circuit provides switching properties with reduced switching stress for the power device and the gate driving circuit.

According to an example, the feedback detection circuit comprises a power device voltage detection circuit, being connected between the power device and the PWM control unit, wherein the feedback information comprises a drain-source-voltage of the power device. The PWM control unit is configured for modulating the interleaved buck converter circuit based on a peak requirement of the drain-source-voltage to control the gate voltage during shutdown of the power device.

The term "peak requirement of the drain-source-voltage", as used herein, relates to a requirement of a maximum value of the drain-source-voltage. The drain-source-voltage peak of a power device shall not be over a rated voltage of the power device. For instance, if a SiC device rated voltage is 1,2kV, the peak requirement of drain-source-voltage preferably is lower than 1,2kV. Alternatively, the peak requirement can be different, such as 1150V or 1000V. This depends on specific system design requirements.

In contrast to a conventional gate driver, the gate driving circuit does not just drive the gate voltage to the negative supply voltage in order to shut the power device down, but the PWM control unit is configured for modulating the interleaved buck converter circuit to apply a gate voltage that at least partly is variable between the negative supply voltage and the positive supply voltage. In other words, the gate voltage during shutdown of the power device switches at least partly between the positive supply voltage and the negative supply voltage.

Preferably, during shutdown, the progression of the drain-source-voltage comprises a low slope section, a high slope section and a peak section, wherein in the low slope section, the drain-source-voltage raises with a low slope, wherein in the high slope section, the drain-source-voltage raises with a high slope, wherein the low slope is lower than the high slope, wherein in the peak section, the drain-source-voltage forms a peak.

In this case, the PWM control unit is configured for modulating the interleaved buck converter circuit to control the gate voltage to the negative supply voltage in the low slope section and the high slope section and is configured for modulating the interleaved buck converter circuit based on the drain-source-voltage to control the gate voltage to a pulse width modulated voltage in the peak section.

Applying a pulse width modulated voltage to the gate in the peak section instead of only applying the negative supply voltage leads to a suppression of the drain-source-voltage during shutdown of the power device.

Thus, the gate driving circuit provides switching properties, in particular shutdown properties, with reduced switching stress for the power device and the gate driving circuit.

According to an example, the feedback detection circuit comprises a feedback resistor circuit, being connected between the interleaved buck converter circuit and the gate, wherein the feedback information comprises a measured gate current of the power device. The PWM control unit is configured for modulating the interleaved buck converter circuit based on the peak requirement of the drain-source-voltage and the measured gate current to control the gate current during shutdown of the power device.

In other words, in addition to the peak requirement of the drain-source-voltage, the PWM control unit also considers the measured gate current of the power device.

Thus, in this case, the PWM control unit is configured for modulating the interleaved buck converter circuit to control the gate voltage to the negative supply voltage in the low slope section and the high slope section and is configured for modulating the interleaved buck converter circuit based on the drain-source-voltage to control the gate voltage to a pulse width modulated voltage in the peak section. In addition, the PWM control unit is configured for modulating the interleaved buck converter circuit based on the measured gate current to control the gate current in the peak section.

Due to the feedback resistor circuit, the PWM control unit always has access to the gate current during switching. This offers the possibility of monitor a health status of the power device by measuring the gate current.

Controlling the gate current in the peak section further leads to a suppression of the drain-source-voltage during shutdown of the power device.

Thus, the gate driving circuit provides switching properties, in particular shutdown properties, with reduced switching stress for the power device and the gate driving circuit.

According to an example, the feedback information comprises a voltage change rate of the drain-source-voltage of the power device. The PWM control unit is configured for modulating the interleaved buck converter circuit based on a slope requirement of the voltage change rate of the drain-source-voltage to control the gate voltage during shutdown of the power device.

In other words, in addition to the peak requirement of the drain-source-voltage, the PWM control unit also considers the voltage change rate of the drain-source-voltage.

Thus, in this case, the PWM control unit is configured for modulating the interleaved buck converter circuit to control the gate voltage to the negative supply voltage in the low slope section. The PWM control unit is further configured for modulating the interleaved buck converter circuit based on the drain-source-voltage and the voltage change rate of the drain-source-voltage to control the gate voltage to a pulse width modulated voltage in the peak section. In addition, the PWM control unit is configured for modulating the interleaved buck converter circuit based on the voltage change rate of the drain-source-voltage to control the gate voltage to a pulse width modulated voltage in the high slope section.

Controlling the gate voltage in the peak section and the high slope section further leads to a suppression of the drain-source-voltage during shutdown of the power device.

Thus, the gate driving circuit provides switching properties, in particular shutdown properties, with reduced switching stress for the power device and the gate driving circuit.

According to an example, the feedback detection circuit comprises a feedback resistor circuit, being connected between the interleaved buck converter circuit and the gate, wherein the feedback information comprises a measured gate current of the power device. The PWM control unit is configured for modulating the interleaved buck converter circuit based on the peak requirement of the drain-source-voltage, the slope requirement of the voltage change rate of the drain-source-voltage and the measured gate current to control the gate current during shutdown of the power device.

In other words, in addition to the peak requirement of the drain-source-voltage, the PWM control unit also considers the voltage change rate of the drain-source-voltage and the measured gate current of the power device.

Thus, in this case, the PWM control unit is configured for modulating the interleaved buck converter circuit to control the gate voltage to the negative supply voltage in the low slope section. The PWM control unit is further configured for modulating the interleaved buck converter circuit based on the drain-source-voltage and the voltage change rate of the drain-source-voltage to control the gate voltage to a pulse width modulated voltage in the peak section. In addition, the PWM control unit is configured for modulating the interleaved buck converter circuit based on the voltage change rate of the drain-source-voltage to control the gate voltage to a pulse width modulated voltage in the high slope section. In addition, the PWM control unit is configured for modulating the interleaved buck converter circuit based on the measured gate current to control the gate current in the peak section and the high slope section.

Controlling the gate voltage and the gate current in the peak section and the high slope section further leads to a suppression of the drain-source-voltage during shutdown of the power device.

Thus, the gate driving circuit provides switching properties, in particular shutdown properties, with reduced switching stress for the power device and the gate driving circuit.

According to an example, the power device voltage detection circuit comprises a sensing resistor and at least one sensing capacity, wherein the sensing resistor and the at least one sensing capacity are connected in parallel, wherein the drain-source-voltage and the voltage change rate of the drain-source-voltage is detected based on a voltage drop on a circuit node between the sensing resistor and the at least one sensing capacity.

According to an example, the feedback detection circuit comprises a power device current detection circuit, being connected between the power device and the PWM control unit, wherein the feedback information comprises a drain-source-current of the power device. The PWM control unit is configured for modulating the interleaved buck converter circuit based on a peak requirement of the drain-source-current to control the gate voltage during startup of the power device.

The term "peak requirement of the drain-source-current", as used herein, relates to a requirement of a maximum value of the drain-source-current.

In contrast to a conventional gate driver, the gate driving circuit does not just drive the gate voltage to the positive supply voltage in order to start up the power device, but the PWM control unit is configured for modulating the interleaved buck converter circuit to apply a gate voltage that at least partly is variable between the negative supply voltage and the positive supply voltage. In other words, the gate voltage during startup of the power device switches at least partly between the positive supply voltage and the negative supply voltage.

Preferably, during startup, the progression of the drain-source-current comprises a slope section and a peak section, wherein in the slope section, the drain-source-current raises with a slope, wherein in the peak section, the drain-source-current forms a peak. The drain-source-current peak of a device shall not be over a maximum single time switching on current of a power device. For instance, if a SiC device rated single time switching on current is 1,2kA, the peak requirement of the drain-source-current preferably is lower than 1,2kA. The peak requirement can be different, for example could be lower, such as 1000A, or even lower 800A. This depends on specific system design requirements, such as loss, efficiency.

In this case, the PWM control unit is configured for modulating the interleaved buck converter circuit to control the gate voltage to the positive supply voltage in the slope section and is configured for modulating the interleaved buck converter circuit based on the drain-source-current to control the gate voltage to a pulse width modulated voltage in the peak section.

Applying a pulse width modulated voltage to the gate in the peak section instead of only applying the positive supply voltage leads to a suppression of the drain-source-current during startup of the power device.

Thus, the gate driving circuit provides switching properties, in particular startup properties, with reduced switching stress for the power device and the gate driving circuit.

According to an example, the feedback detection circuit comprises a feedback resistor circuit, being connected between the interleaved buck converter circuit and the gate, wherein the feedback information comprises a measured gate current of the power device. The PWM control unit is configured for modulating the interleaved buck converter circuit based on the peak requirement of the drain-source-current and the measured gate current to control the gate current during startup of the power device.

In other words, in addition to the peak requirement of the drain-source-current, the PWM control unit also considers the measured gate current of the power device.

Thus, in this case, the PWM control unit is configured for modulating the interleaved buck converter circuit to control the gate voltage to the positive supply voltage in the slope section and is configured for modulating the interleaved buck converter circuit based on the drain-source-current to control the gate voltage to a pulse width modulated voltage in the peak section. In addition, the PWM control unit is configured for modulating the interleaved buck converter circuit based on the measured gate current to control the gate current in the peak section.

Due to the feedback resistor circuit, the PWM control unit always has access to the gate current during switching. This offers the possibility of monitor a health status of the power device by measuring the gate current.

Controlling the gate current in the peak section further leads to a suppression of the drain-source-current during startup of the power device.

Thus, the gate driving circuit provides switching properties, in particular startup properties, with reduced switching stress for the power device and the gate driving circuit.

According to an example, the feedback information comprises a current change rate of the drain-source-current of the power device. The PWM control unit is configured for modulating the interleaved buck converter circuit based on a slope requirement of the drain-source-current to control the gate voltage during startup of the power device.

In other words, in addition to the peak requirement of the drain-source-current, the PWM control unit also considers the current change rate of the drain-source-current.

Thus, in this case, the PWM control unit is further configured for modulating the interleaved buck converter circuit based on the drain-source-current and the current change rate of the drain-source-current to control the gate voltage to a pulse width modulated voltage in the peak section. In addition, the PWM control unit is configured for modulating the interleaved buck converter circuit based on the current change rate of the drain-source-current to control the gate voltage to a pulse width modulated voltage in the slope section.

Controlling the gate voltage in the peak section and the slope section further leads to a suppression of the drain-source-current during shutdown of the power device.

Thus, the gate driving circuit provides switching properties, in particular startup properties, with reduced switching stress for the power device and the gate driving circuit.

According to an example, the feedback detection circuit comprises a feedback resistor circuit, being connected between the interleaved buck converter and the gate, wherein the feedback information comprises a measured gate current circuit of the power device. The PWM control unit is configured for modulating the interleaved buck converter circuit based on the peak requirement of the drain-source-current, the slope requirement of the drain-source-current and the measured gate current to control the gate current during startup of the power device.

In other words, in addition to the peak requirement of the drain-source-current, the PWM control unit also considers the current change rate of the drain-source-current and the measured gate current of the power device.

Thus, in this case, the PWM control unit is further configured for modulating the interleaved buck converter circuit based on the drain-source-current and the current change rate of the drain-source-current to control the gate voltage to a pulse width modulated voltage in the peak section. In addition, the PWM control unit is configured for modulating the interleaved buck converter circuit based on the current change rate of the drain-source-current to control the gate voltage to a pulse width modulated voltage in the slope section. In addition, the PWM control unit is configured for modulating the interleaved buck converter circuit based on the measured gate current to control the gate current in the peak section and the slope section.

Controlling the gate voltage and the gate current in the peak section and the slope section further leads to a suppression of the drain-source-current during shutdown of the power device.

Thus, the gate driving circuit provides switching properties, in particular startup properties, with reduced switching stress for the power device and the gate driving circuit.

According to an example, the power device current detection circuit comprises a stray inductance, which is disposed between a power source and a source of the power device, wherein the drain-source-current and the current change rate of the drain-source-current is detected based on a voltage drop of the stray inductance.

According to an example, the power device comprises a wide band gap device, in particular a Silicon Carbide, SIC, power device. Further preferably, the power device comprises a insulated-gate bipolar transistor, IGBT.

According to an example, the interleaved buck converter circuit comprises a plurality of push-pull circuits, wherein the plurality of push-pull circuits is connected in parallel to each other.

Preferably, each push-pull circuit comprises two switching devices, in particular transistors, further preferably metal-oxide-semiconductor field-effect transistors, MOSFETs. Further preferably, the switching devices comprise Gallium Nitride, GaN, MOSFETs and/or Silicone, Si, MOSFETs. Those MOSFETs provide relatively fast witching properties. This allows providing an interleaved buck converter circuit with a relatively high frequency.

The push-pull circuit comprises two switching devices, in particular a complementary pair of switching devices, one dissipating or sinking current from the load to ground or a negative power supply, and the other supplying or sourcing current to the load from a positive power supply.

When modulating interleaved buck converter circuit each of the push-pull circuits are controlled through the respective gates of the switching devices of the push-pull circuits.

According to a second aspect, a method for controlling a gate driving circuit for a power device, wherein the gate driving circuit comprises an interleaved buck converter circuit, being connected to a gate of the power device to drive the gate, a pulse width modulation, PWM, control unit, being connected to the interleaved buck converter circuit, at least one feedback detection circuit, being connected between the power device, comprises the steps. Providing, by the at least one feedback detection circuit, feedback information of the power device to the PWM control unit. Modulating, by the PWM control unit, the interleaved buck converter circuit based on the feedback information to control a gate voltage or a gate current of the power device.

The method may be at least partly computer-implemented, and may be implemented in software or in hardware, or in software and hardware. Further, the method may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a third aspect, a power device system comprises a power device and a gate driving circuit for the power device, as described herein.

It should be noted that the above examples may be combined with each other irrespective of the aspect involved. Accordingly, the method may be combined with structural features and, likewise, the apparatus may be combined with features described above with regard to the method.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a schematic view of a gate driving circuit for a power device.
- Figure 2: shows a schematic diagram of a drain-source-voltage peak suppress mode during shutdown using voltage control mode.
- Figure 3: shows a schematic diagram of a drain-source-voltage peak suppress mode during shutdown using current control mode.
- Figure 4: shows a schematic diagram of a drain-source-voltage peak suppress mode and dv/dt control during shutdown using voltage control mode.
- Figure 5: shows a schematic diagram of a drain-source-voltage peak suppress mode and dv/dt control during shutdown using current control mode.
- Figure 6: shows a schematic diagram of a drain-source-current peak suppress mode during startup using voltage control mode.
- Figure 7: shows a schematic diagram of a drain-source-current peak suppress mode during startup using current control mode.
- Figure 8: shows a schematic diagram of a drain-source-current peak suppress mode and di/dt control during startup using voltage control mode.
- Figure 9: shows a schematic diagram of a drain-source-current peak suppress mode and di/dt control during startup using current control mode.

### DETAILED DESCRIPTION

The Figures are merely schematic representations and serve only to illustrate examples of the disclosure. Identical or equivalent elements are in principle provided with the same reference signs.

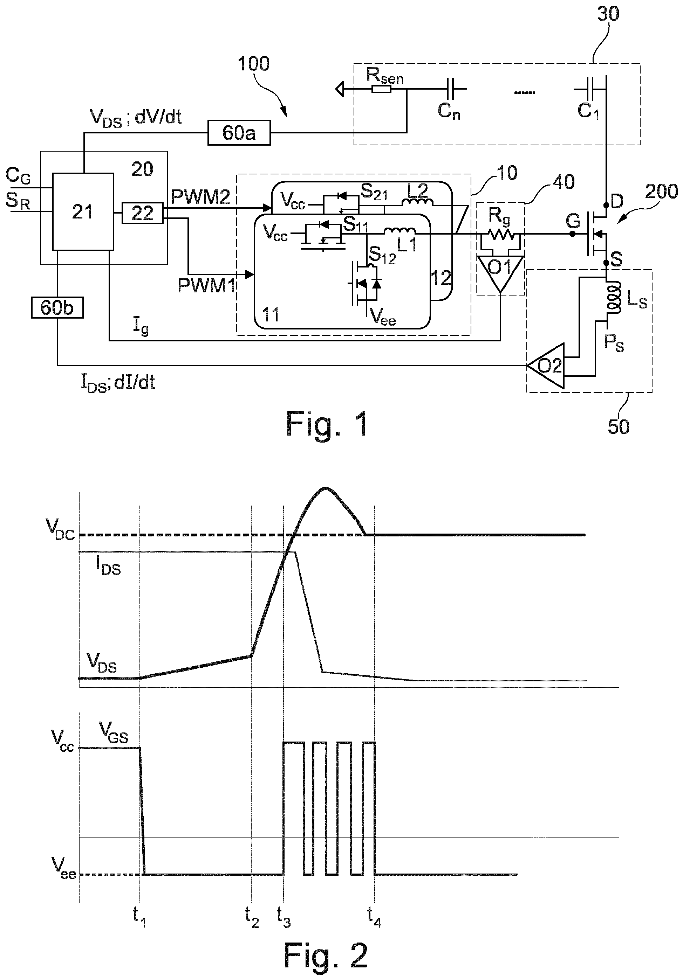

Figure 1 shows a schematic view of a gate driving circuit 100 for a power device 200. The gate driving circuit 100 comprises an interleaved buck converter circuit 10, a pulse width modulation, PWM, control unit 20 and three feedback detection circuits, namely a power device voltage detection circuit 30, a feedback resistor circuit 40 and a power device current detection circuit 50. The gate driving circuit 100 comprises a gate connector, being connected to a gate G of the power device 200, a source connector, being connected to a source S of the power device 200 and a drain connector, being connected to a drain D of the power device 200. Due to the feedback resistor circuit 40, the PWM control unit 20 always has access to the gate current IG during switching. This offers the possibility of monitor a health status of the power device 200 by measuring the gate current. The proposed gate driving circuit 100 can be also be integrated into a single customized integrated circuit. This will not only simplify the use of the proposed solution but also provide a smaller volume and a higher reliability.

The power device voltage detection circuit 30, the feedback resistor circuit 40 and the power device current detection circuit 50 are connected between the PWM control unit 20 and the power device 200 or in particular the power device connectors. In particular, the power device voltage detection circuit 30 comprises a power device voltage detection input, which is connected to the drain connector, and a power device voltage detection output, which is connected to the PWM control unit 20, in particular the gate logic control unit 21. The feedback resistor circuit 40 comprises a feedback resistor input, which is connected to the interleaved buck converter circuit 10, and a feedback resistor output, which is connected to the PWM control unit 20. The power device current detection circuit 50 comprises a power device current input, which is connected to the source connector, and a power device current output, which is connected to the PWM control unit 20.

The interleaved buck converter circuit 10 is connected between the PWM control unit 20 and the gate connector. The interleaved buck converter circuit 10 comprises a first push-pull-circuit 11 and a second push-pull circuit 12, being connected in parallel to each other. The first push-pull-circuit 11 comprises a first pull-transistor S11 connected to a positive supply voltage and a first push-transistor S12 connected to a negative supply voltage. Between the first pull-transistor S11 and the first push-transistor S12 a first inductance L1 is connected. The second push-pull circuit 12 comprises a first pull-transistor S21 connected to a positive supply voltage and a first push-transistor (not shown) connected to a negative supply voltage. Between the second pull-transistor S21 and the second push-transistor a second inductance L2 is connected. The interleaved buck converter circuit 10 is configured for providing a gate voltage V_{G} and a gate current I_{G} to the gate connector. Between the gate connector and the interleaved buck converter 10, a measurement resistance R_{g} is provided. The measurement resistance R_{g} is part of the feedback resistor circuit 40.

The power device voltage detection circuit 30 is configured for providing a drain-source-voltage V_{DS} of the power device and a voltage change rate of the drain-source-voltage dV/dt of the power device to the PWM control unit 20.

The feedback resistor circuit 40 is configured for providing a measured gate current I_{g} to the PWM control unit 20.

The power device current detection circuit 50 is configured for providing a drain-source-current I_{DS} of the power device and a current change rate of the drain-source-current dI/dt of the power device to the PWM control unit 20.

The PWM control unit 20 comprises a gate logic control unit 21 and a PWM signal unit 22. The gate logic control unit 21 is provided with feedback information, namely the drain-source-voltage V_{DS}, the voltage change rate of the drain-source-voltage dV/dt, the measured gate current Ig, the drain-source-current I_{DS} and a current change rate of the drain-source-current dI/dt. Furthermore, the gate logic control unit 21 is provided with a gate control signal C_{G} and a reference signal S_{R}.

The PWM control unit 21 is configured for modulating the interleaved buck converter circuit 10 based on the feedback information to control a gate voltage V_{GS} or a gate current I_{G} of the power device 200. Therefore, the gate logic control unit 21 uses the reference signal S_{R} the control signal C_{G} and the feedback information to determine a PWM control signal. The PWM control signal is provided to the PWM signal unit 22. The PWM signal unit 22 uses the PWM control signal to determine a PWM signal PWM1, PWM2 for each of the push-pull-circuits 11, 12, in particular a first PWM signal PWM1 for the first push-pull-circuit 11 and a second PWM signal PWM2 for the second push-pull-circuit 12.

The power device voltage detection circuit 30 comprises a sensing resistor Rₛₑₙ and a plurality of sensing capacities C₁-Cₙ, wherein the sensing resistor Rₛₑₙ and the plurality of sensing capacities C₁-Cₙ are connected in parallel. The drain-source-voltage V_{DS} and the voltage change rate of the drain-source-voltage dV/dt is detected based on a voltage drop on a circuit node between the sensing resistor Rₛₑₙ and the plurality of sensing capacities C₁-Cₙ. The plurality of sensing capacities C₁-Cₙ are connected in series. The sensing resistor Rₛₑₙ is connected to a ground connector.

The feedback resistor circuit 40 comprises a measurement resistor R_{g} and a first operation amplifier O1. The first operation amplifier O1 is configured for determining a measurement voltage, based on which together with the known value of the measurement resistor R_{g}, the measured gate current Ig can be determined. Consequently, the gate driving circuit 100 only requires one gate resistor, namely the measurement resistor R_{g}, one push-pull circuit, namely the interleaved buck converter circuit 10, and no extra inductor.

The power device current detection circuit 50 comprises a stray inductance L_{S}, which is disposed between a power source P_{S} and the source connector. The drain-source-current I_{DS} and the current change rate of the drain-source-current dI/dt is detected based on a voltage drop of the stray inductance L_{S}, which is determined by a second operation amplifier O2.

Between the power device voltage detection output and the PWM control unit 20, a first filter 60a is disposed. Between the power device current detection output and the PWM control unit 20, a second filter 60b is disposed.

The gate driving circuit 100 thus is configured for modulating the interleaved buck converter circuit 10 based on the feedback information to control a gate voltage V_{GS} or a gate current I_{G} of the power device 200, in particular during shutdown or startup of the power device 200.

Figure 2 shows a schematic diagram of a drain-source-voltage peak suppress mode during shutdown using voltage control mode. Figure 2 illustrates how the drain-source-voltage V_{DS} and the drain-source-current I_{DS} changes over time during shutdown of the power device. Before a first time point t1, the power device is activated or in other words conducts. Thus, the drain-source-voltage V_{DS} is nearly zero and the drain-source-current I_{DS} is on a high operating value. Thus, before the first time points t1, the gate voltage V_{G} is set by the gate driving circuit 100 to the positive supply voltage Vcc. Preferably, the first time point t1 is defined as the time point at which the drain-source-voltage V_{DS} starts to increase.

At the first time point t1, the power device 200 should be shutdown. As such, the gate voltage V_{G} is set by the gate driving circuit 100 to the negative supply voltage Vee.

In a low slope section between the first time point t1 and a second time point t2, the drain-source-voltage V_{DS} raises at a relatively low rate (or slope). The power device 200 still conducts well. Thus, the drain-source-current I_{DS} still remains at the high operating value. The gate voltage V_{G} is still set by the gate driving circuit 100 to the negative supply voltage Vee. Preferably, the second time point t2 is defined as the time point at which the drain-source-voltage V_{DS} reaches 10% of the supply voltage V_{DC} of the power device.

In a high slope section between the second time point t2 and a third time point t3, the drain-source-voltage V_{DS} raises at a relative high rate (or slope). The power device 200 still conducts well. Thus, the drain-source-current I_{DS} still remains at the high operating value. The gate voltage V_{G} is still set by the gate driving circuit 100 to the negative supply voltage Vee. Preferably, the third time point 3 is defined as the time point at which the drain-source-voltage V_{DS} reaches 90% of the supply voltage V_{DC} of the power device.

In a peak section between the third time point t3 and a fourth time point t4, the drain-source-voltage performs a heavy peak that extends the disconnect voltage V_{DC}, which is the value of the drain-source-voltage V_{DS} after the power device 200 has been shutdown. In the peak section, the gate voltage V_{G} is modulated by the gate driving circuit 100 to a PWM voltage based on a peak requirement of the drain-source-voltage, which dynamically switches between the high supply voltage Vcc and the negative supply voltage Vee. This pulse width modulated voltage, instead of just leaving the gate voltage V_{G} at the negative supply voltage Vee, leads to a suppression of the drain-source-voltage V_{DS} during shutdown of the power device 200. In other words, the peak of the drain-source-voltage V_{DS} can be reduced. Thus, the gate driving circuit provides switching properties, in particular shutdown properties, with reduced switching stress for the power device 200 and the gate driving circuit 100. Preferably, the fourth time point t4 is defined as the time point at which the drain-source-voltage V_{DS} reaches 90% of the supply voltage V_{DC} of the power device after the peak of the drain-source-voltage V_{DS}.

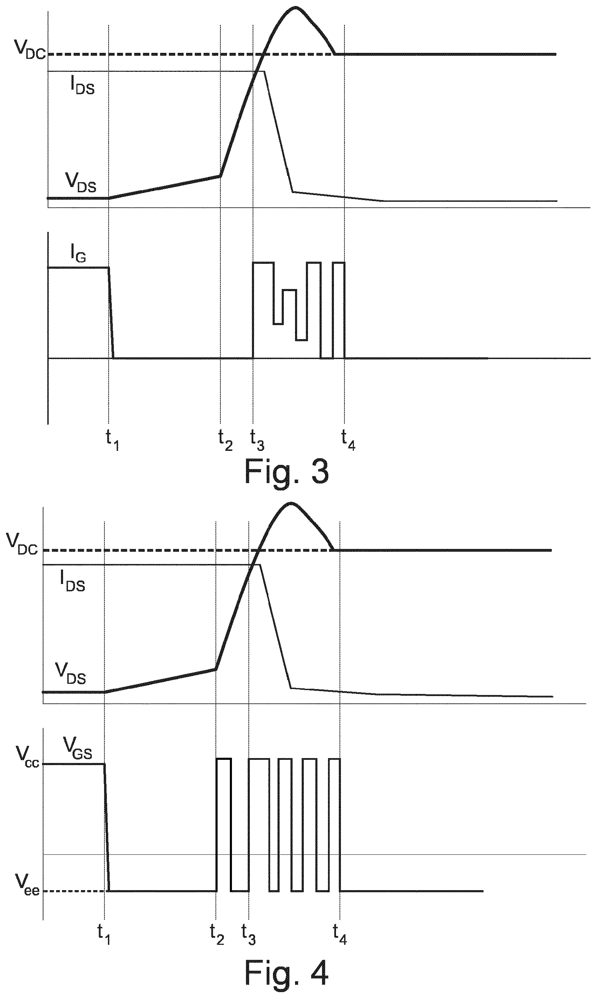

Figure 3 shows a schematic diagram of a drain-source-voltage peak suppress mode during shutdown using current control mode. In addition to the peak requirement of the drain-source-voltage V_{DS} illustrated in Figure 2, the PWM control unit 20 also considers the measured gate current Ig of the power device 200. Thus, in this case, the PWM control unit 20 is configured for modulating the interleaved buck converter circuit 10 to control the gate voltage V_{G} to the negative supply voltage in the low slope section between the first time point t1 and the second time point t2 and the high slope section between the second time point t2 and the third time point t3 and is configured for modulating the interleaved buck converter circuit 10 based on the drain-source-voltage V_{DS} to control the gate voltage V_{G} to a pulse width modulated voltage in the peak section between the third time point t3 and the fourth time point t4. In addition, the PWM control unit 20 is configured for modulating the interleaved buck converter circuit 10 based on the measured gate current Ig to control the gate current I_{G} in the peak section between the third time point t3 and the fourth time point t4.

Controlling the gate current I_{G} in the peak section further leads to a suppression of the drain-source-voltage V_{DS} during shutdown of the power device 200. In other words, the peak of the drain-source-voltage V_{DS} can be reduced. Thus, the gate driving circuit provides switching properties, in particular shutdown properties, with reduced switching stress for the power device 200 and the gate driving circuit 100.

Figure 4 shows a schematic diagram of a drain-source-voltage peak suppress mode and dv/dt control during shutdown using voltage control mode. In addition to the peak requirement of the drain-source-voltage V_{DS} illustrated in Figure 2, the PWM control unit 20 also considers the voltage change rate of the drain-source-voltage dV/dt. Thus, in this case, the PWM control unit 20 is configured for modulating the interleaved buck converter circuit to control the gate voltage to the negative supply voltage in the low slope section. The PWM control unit is further configured for modulating the interleaved buck converter circuit 10 based on the drain-source-voltage V_{DS} and the voltage change rate of the drain-source-voltage dV/dt to control the gate voltage V_{G} to a pulse width modulated voltage in the peak section. In addition, the PWM control unit 20 is configured for modulating the interleaved buck converter circuit 10 based on the voltage change rate of the drain-source-voltage dV/dt to control the gate voltage V_{G} to a pulse width modulated voltage in the high slope section between the second time point t2 and the third time point t3.

Controlling the gate voltage in the peak section and the high slope section further leads to a suppression of the drain-source-voltage V_{DS} during shutdown of the power device. In other words, the peak of the drain-source-voltage V_{DS} can be reduced. Thus, the gate driving circuit 20 provides switching properties, in particular shutdown properties, with reduced switching stress for the power device 200 and the gate driving circuit 100.

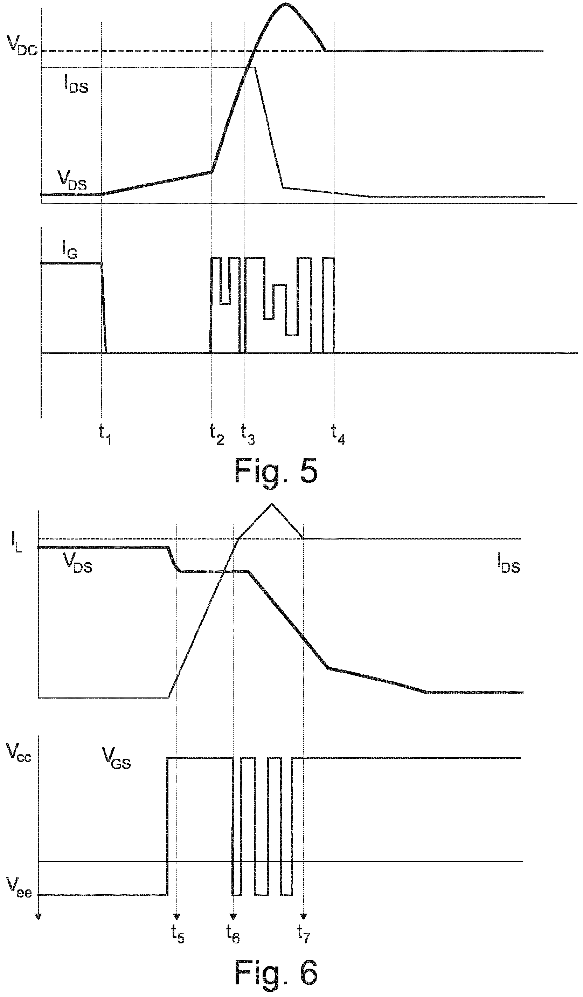

Figure 5 shows a schematic diagram of a drain-source-voltage peak suppress mode and dv/dt control during shutdown using current control mode. In addition to the peak requirement of the drain-source-voltage V_{DS} illustrated in Figure 2, the PWM control unit 20 also considers the voltage change rate of the drain-source-voltage dV/dt and the measured gate current Ig of the power device 200.

Thus, in this case, the PWM control unit 20 is configured for modulating the interleaved buck converter circuit 10 to control the gate voltage V_{G} to the negative supply voltage Vee in the low slope section between the first time point t1 and the second time point t2. The PWM control unit 20 is further configured for modulating the interleaved buck converter circuit 10 based on the drain-source-voltage V_{DS} and the voltage change rate of the drain-source-voltage dV/dt to control the gate voltage V_{G} to a pulse width modulated voltage in the peak section between the third time point t3 and the fourth time point t4. In addition, the PWM control unit 20 is configured for modulating the interleaved buck converter circuit 10 based on the voltage change rate of the drain-source-voltage dV/dt to control the gate voltage V_{G} to a pulse width modulated voltage in the high slope section between the second time point t2 and the third time point t3. In addition, the PWM control unit 20 is configured for modulating the interleaved buck converter circuit 10 based on the measured gate current I_{g} to control the gate current I_{G} in the peak section and the high slope section.

Controlling the gate voltage V_{G} and the gate current I_{G} in the peak section and the high slope section further leads to a suppression of the drain-source-voltage V_{DS} during shutdown of the power device. In other words, the peak of the drain-source-voltage V_{DS} can be reduced.

Thus, the gate driving circuit 100 provides switching properties, in particular shutdown properties, with reduced switching stress for the power device 200 and the gate driving circuit 100.

Figure 6 shows a schematic diagram of a drain-source-current peak suppress mode during startup using voltage control mode. Figure 6 illustrates how the drain-source-voltage V_{DS} and the drain-source-current I_{DS} changes over time during startup of the power device 200. Before a fifth time point t5, the power device 200 is deactivated or in other words blocks. Thus, the drain-source-voltage V_{DS} is high and the drain-source-current I_{DS} is zero. Thus, before the fifth time point t5, the gate voltage V_{G} is set by the gate driving circuit 100 to the negative supply voltage Vee. Preferably, the fifth time point t5 is defined as the time point at which the drain-source-current I_{DS} reaches 10% of a power device current I_{L}.

At the fifth time point t5, the power device 200 should be started. As such, the gate voltage V_{G} is set by the gate driving circuit 100 to the positive supply voltage Vcc.

In a slope section between the fifth time point t5 and a sixth time point t6, the drain-source-current I_{DS} raises. The drain-source-voltage V_{DS} starts to fall. The gate voltage VG is still set by the gate driving circuit 100 to the positive supply voltage Vcc.

In a peak section between the sixth time point t6 and a seventh time point t7, the drain-source-current performs a heavy peak that extends a value of the drain-source-voltage V_{DS} after the power device 200 has been started up. In the peak section, the gate voltage V_{G} is modulated by the gate driving circuit 100 to a PWM voltage based on a peak requirement of the drain-source-current, which dynamically switches between the high supply voltage Vcc and the negative supply voltage Vee. This pulse width modulated voltage, instead of just leaving the gate voltage V_{G} at the positive supply voltage Vcc, leads to a suppression of the drain-source-current I_{DS} during startup of the power device 200. In other words, the peak of the drain-source-current I_{DS} can be reduced. Thus, the gate driving circuit 200 provides switching properties, in particular startup properties, with reduced switching stress for the power device 200 and the gate driving circuit 100. Preferably, the sixth time point t6 is defined as the time point at which the drain-source-current I_{DS} reaches 90% of a power device current I_{L}.

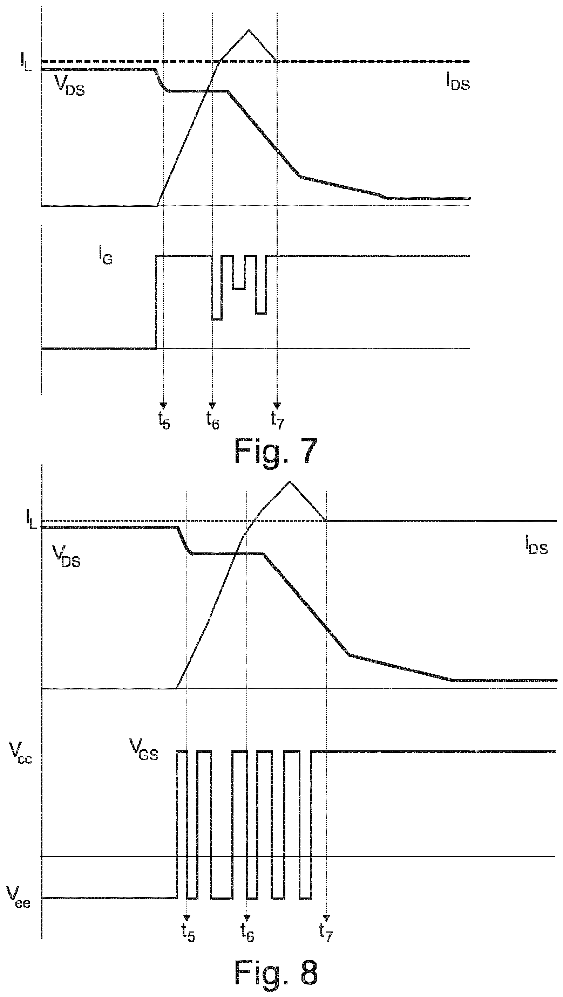

Figure 7 shows a schematic diagram of a drain-source-current peak suppress mode during startup using current control mode. In addition to the peak requirement of the drain-source-current V_{DS} illustrated in Figure 6, the PWM control unit 20 also considers the measured gate current Ig of the power device 200. Thus, in this case, the PWM control unit is configured for modulating the interleaved buck converter circuit 10 to control the gate voltage V_{G} to the positive supply voltage Vcc in the slope section between the fifth time point t5 and the sixth time point t6 and is configured for modulating the interleaved buck converter circuit 10 based on the drain-source-current I_{DS} to control the gate voltage V_{G} to a pulse width modulated voltage in the peak section between the sixth time point t6 and the seventh time point t7. In addition, the PWM control unit 20 is configured for modulating the interleaved buck converter circuit 10 based on the measured gate current Ig to control the gate current I_{G} in the peak section. Preferably, the seventh time point t7 is defined as the time point at which the drain-source-current I_{DS} reaches the power device current I_{L} after the current peak of the drain-source-current I_{DS}.

Controlling the gate current I_{G} in the peak section further leads to a suppression of the drain-source-current I_{DS} during shutdown of the power device 200. In other words, the peak of the drain-source-current I_{DS} can be reduced. Thus, the gate driving circuit 100 provides switching properties, in particular startup properties, with reduced switching stress for the power device 200 and the gate driving circuit 100.

Figure 8 shows a schematic diagram of a drain-source-current peak suppress mode and di/dt control during startup using voltage control mode. In addition to the peak requirement of the drain-source-current I_{DS} as illustrated in Figure 6, the PWM control unit 20 also considers the current change rate of the drain-source-current dI/dt.

Thus, in this case, the PWM control unit 20 is further configured for modulating the interleaved buck converter circuit 10 based on the drain-source-current I_{DS} and the current change rate of the drain-source-current dI/dt to control the gate voltage V_{G} to a pulse width modulated voltage in the peak section. In addition, the PWM control unit 20 is configured for modulating the interleaved buck converter circuit 10 based on the current change rate of the drain-source-current dI/dt to control the gate voltage V_{G} to a pulse width modulated voltage in the slope section.

Controlling the gate voltage V_{G} in the peak section and the slope section further leads to a suppression of the drain-source-current during shutdown of the power device.

Thus, the gate driving circuit provides switching properties, in particular startup properties, with reduced switching stress for the power device and the gate driving circuit.

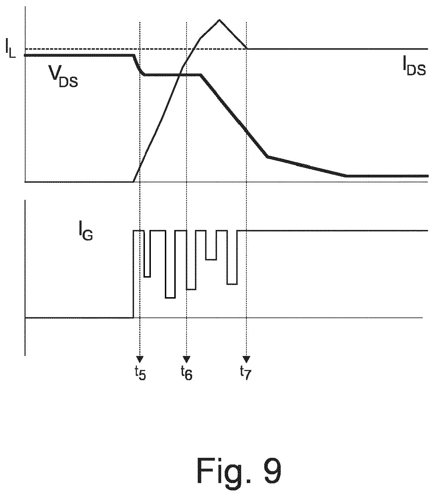

Figure 9 shows a schematic diagram of a drain-source-current peak suppress mode and di/dt control during startup using current control mode. In addition to the peak requirement of the drain-source-current I_{DS} as illustrated in Figure 6, the PWM control unit 20 also considers the current change rate of the drain-source-current dI/dt and the measured gate current Ig of the power device 200. Thus, in this case, the PWM control unit 20 is further configured for modulating the interleaved buck converter circuit 10 based on the drain-source-current I_{DS} and the current change rate of the drain-source-current dI/dt to control the gate voltage V_{G} to a pulse width modulated voltage in the peak section. In addition, the PWM control unit 20 is configured for modulating the interleaved buck converter circuit 10 based on the current change rate of the drain-source-current dI/dt to control the gate voltage to a pulse width modulated voltage in the slope section. In addition, the PWM control unit 20 is configured for modulating the interleaved buck converter circuit 10 based on the measured gate current I_{g} to control the gate current I_{G} in the peak section and the slope section.

Controlling the gate voltage V_{G} and the gate current I_{G} in the peak section and the slope section further leads to a suppression of the drain-source-current I_{DS} during shutdown of the power device. In other words, the peak of the drain-source-current I_{DS} can be reduced. Thus, the gate driving circuit 100 provides switching properties, in particular startup properties, with reduced switching stress for the power device 200 and the gate driving circuit 100.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 100: gate driving circuit
- 10: interleaved buck converter circuit
- 11: first push-pull-circuit
- 12: second push-pull-circuit
- 20: PWM control unit
- 21: gate logic control unit
- 22: PWM signal unit
- 30: power device voltage detection circuit
- 40: feedback resistor circuit
- 50: power device current detection circuit
- 60a: first filter
- 60b: second filter
- G: gate
- S: source
- D: drain
- V_{DS}: drain-source-voltage
- dV/dt: change rate of the drain-source-voltage
- I_{DS}: drain-source-current
- dI/dt: change rate of the drain-source-current
- Vcc: positive supply voltage
- Vee: negative supply voltage
- L1: first inductance
- L2: second inductance
- I_{G}: gate current
- I_{g}: measured gate current
- C_{G}: gate control signal
- S_{R}: reference signal
- O1: first operational amplifier
- O2: second operational amplifier
- PWM1: first PWM signal
- PWM2: second PWM signal
- C₁-Cₙ: sensing capacities
- Rₛₑₙ: sensing resistor
- L_{S}: stray inductance
- t1: first time point
- t2: second time point
- t3: third time point
- t4: fourth time point
- P_{S}: power source
- 200: power device

## Claims

1. A gate driving circuit for a power device, comprising:
an interleaved buck converter circuit (10), being connected to a gate (G) of the power device (200) to drive the gate (G),
wherein the interleaved buck converter circuit (10) comprises a plurality of push-pull circuits (L1, L2), wherein the plurality of push-pull circuits (L1, L2) is connected in parallel to each other;
a pulse width modulation, PWM, control unit, being connected to the interleaved buck converter circuit (10);
at least one feedback detection circuit, being connected between the power device (200) and the PWM control unit (20) and being configured for providing feedback information of the power device (200) to the PWM control unit (20);
wherein the PWM control unit (20) is configured for modulating the interleaved buck converter circuit (10) based on the feedback information to control a gate voltage (V_{GS}) or a gate current (I_{G}) of the power device (200).

2. The gate driving circuit of claim 1,
wherein the feedback detection circuit comprises a power device voltage detection circuit (30), being connected between the power device (200) and the PWM control unit (20), wherein the feedback information comprises a drain-source-voltage (V_{DS}) of the power device (200);
wherein the PWM control unit (20) is configured for modulating the interleaved buck converter circuit (10) based on a peak requirement of the drain-source-voltage (V_{DS}) to control the gate voltage (V_{GS}) during shutdown of the power device (200).

3. The gate driving circuit of claim 2,
wherein the feedback detection circuit comprises a feedback resistor circuit (40), being connected between the interleaved buck converter circuit (10) and the gate, wherein the feedback information comprises a measured gate current (I_{g}) of the power device (200);
wherein the PWM control unit (20) is configured for modulating the interleaved buck converter circuit (10) based on the peak requirement of the drain-source-voltage (V_{DS}) and the measured gate current (I_{g}) to control the gate current (I_{G}) during shutdown of the power device (200).

4. The gate driving circuit of claim 2,
wherein the feedback information comprises a voltage change rate of the drain-source-voltage (dV/dt) of the power device (200);
wherein the PWM control unit (20) is configured for modulating the interleaved buck converter circuit (10) based on a slope requirement of the voltage change rate of the drain-source-voltage (dV/dt) to control the gate voltage (V_{GS}) during shutdown of the power device (200).

5. The gate driving circuit of claim 4,
wherein the feedback detection circuit comprises a feedback resistor circuit (40), being connected between the interleaved buck converter circuit (10) and the gate (G), wherein the feedback information comprises a measured gate current (I_{g}) of the power device;
wherein the PWM control unit (20) is configured for modulating the interleaved buck converter circuit (10) based on the peak requirement of the drain-source-voltage (V_{DS}), the slope requirement of the voltage change rate of the drain-source-voltage (dV/dt) and the measured gate current (I_{g}) to control the gate current (I_{G}) during shutdown of the power device (200).

6. The gate driving circuit of any one of the claims 2 to 5,
wherein the power device voltage detection circuit (30) comprises a sensing resistor (Rₛₑₙ) and at least one sensing capacity (C₁-Cₙ), wherein the sensing resistor (Rₛₑₙ) and the at least one sensing capacity (C₁-Cₙ) are connected in parallel, wherein the drain-source-voltage (V_{DS}) and the voltage change rate of the drain-source-voltage (dV/dt) is detected based on a voltage drop on a circuit node between the sensing resistor (Rₛₑₙ) and the at least one sensing capacity (C₁-Cₙ).

7. The gate driving circuit of any one of the preceding claims,
wherein the feedback detection circuit comprises a power device current detection circuit (50), being connected between the power device (200) and the PWM control unit (20), wherein the feedback information comprises a drain-source-current (I_{DS}) of the power device (200);
wherein the PWM control unit (20) is configured for modulating the interleaved buck converter circuit (10) based on a peak requirement of the drain-source-current (I_{DS}) to control the gate voltage (V_{GS}) during startup of the power device (200).

8. The gate driving circuit of claim 7,
wherein the feedback detection circuit comprises a feedback resistor circuit (40), being connected between the interleaved buck converter circuit (10) and the gate (G), wherein the feedback information comprises a measured gate current (I_{g}) of the power device (200);
wherein the PWM control unit (20) is configured for modulating the interleaved buck converter circuit (10) based on the peak requirement of the drain-source-current (I_{DS}) and the measured gate current (I_{g}) to control the gate current (I_{G}) during startup of the power device (200).

9. The gate driving circuit of claim 7,
wherein the feedback information comprises a current change rate of the drain-source-current (dI/dt) of the power device (200);
wherein the PWM control unit (20) is configured for modulating the interleaved buck converter circuit (10) based on a slope requirement of the drain-source-current (I_{DS}) to control the gate voltage (V_{GS}) during startup of the power device (200).

10. The gate driving circuit of claim 9,
wherein the feedback detection circuit comprises a feedback resistor circuit (40), being connected between the interleaved buck converter circuit (10) and the gate (G), wherein the feedback information comprises a measured gate current (I_{g}) of the power device;
wherein the PWM control unit (20) is configured for modulating the interleaved buck converter circuit (10) based on the peak requirement of the drain-source-current (I_{DS}), the slope requirement of the drain-source-current (I_{DS}) and the measured gate current (I_{g}) to control the gate current (I_{G}) during startup of the power device (200).

11. The gate driving circuit of any one of the claims 7 to 10,
wherein the power device current detection circuit (50) comprises a stray inductance (L_{S}), which is disposed between a power source (P_{S}) and a source (S) of the power device (200), wherein the drain-source-current (I_{DS}) and the current change rate of the drain-source-current (dI/dt) is detected based on a voltage drop of the stray inductance (L_{S}).

12. The gate driving circuit of any one of the preceding claims,
wherein the power device comprises a wide band gap device, in particular a Silicon Carbide, SiC, power device.

13. A method for controlling a gate driving circuit for a power device, wherein the gate driving circuit (100) comprises an interleaved buck converter circuit (10), wherein the interleaved buck converter circuit (10) comprises a plurality of push-pull circuits (L1, L2), and wherein the plurality of push-pull circuits (L1, L2) is connected in parallel to each other, the interleaved buck converter circuit (10) being connected to a gate (G) of the power device (200) to drive the gate (G), a pulse width modulation, PWM, control unit (20), being connected to the interleaved buck converter circuit (10), at least one feedback detection circuit, being connected between the power device (200), comprising the steps:
providing, by the at least one feedback detection circuit, feedback information of the power device to the PWM control unit (20);
modulating, by the PWM control unit (20), the interleaved buck converter circuit (10) based on the feedback information to control a gate voltage (V_{GS}) or a gate current (I_{G}) of the power device (200).

14. Power device system comprising a power device and a gate driving circuit for the power device of any one of the claims 1 to 12, wherein the interleaved buck converter circuit (10) is connected to the gate (G) of the power device (200) to drive the gate (G).

## Patentansprüche

1. Gate-Treiberschaltung für eine Leistungsvorrichtung, Folgendes umfassend:
eine Mehrphasen-Abwärtswandler-Schaltung (10), die mit einem Gate (G) der Leistungsvorrichtung (200) verbunden ist, um das Gate (G) anzutreiben,
wobei die Mehrphasen-Abwärtswandler-Schaltung (10) mehrere Push-Pull-Schaltungen (L1, L2) umfasst, wobei die mehreren Push-Pull-Schaltungen (L1, L2) parallel zueinander geschaltet sind;
eine Pulsweitenmodulation-, PWM-, Steuerungseinheit, die mit der Mehrphasen-Abwärtswandler-Schaltung (10) verschaltet ist;
mindestens eine Rückmeldungserkennungsschaltung, die zwischen die Leistungsvorrichtung (200) und die PWM-Steuerungseinheit (20) geschaltet und dafür konfiguriert ist, Rückmeldungsinformationen der Leistungsvorrichtung (200) an die PWM-Steuerungseinheit (20) bereitzustellen;
wobei die PWM-Steuerungseinheit (20) dafür konfiguriert ist, die Mehrphasen-Abwärtswandler-Schaltung (10) basierend auf den Rückmeldungsinformationen zu modulieren, um eine Gate-Spannung (V_{GS}) oder eine Gate-Stromstärke (I_{G}) der Leistungsvorrichtung (200) zu steuern.

2. Gate-Treiberschaltung nach Anspruch 1,
wobei die Rückmeldungserkennungsschaltung eine Schaltung (30) zum Erkennen der Spannung der Leistungsvorrichtung umfasst, die zwischen die Leistungsvorrichtung (200) und die PWM-Steuerungseinheit (20) eingebunden ist, wobei die Rückmeldungsinformationen eine Drain-Source-Spannung (V_{DS}) der Leistungsvorrichtung (200) umfassen;
wobei die PWM-Steuerungseinheit (20) dafür konfiguriert ist, die Mehrphasen-Abwärtswandler-Schaltung (10) basierend auf einem Spitzenbedarf der Drain-Source-Spannung (V_{DS}) zu modulieren, um die Gate-Spannung (V_{GS}) während einer Abschaltung der Leistungsvorrichtung (200) zu steuern.

3. Gate-Treiberschaltung nach Anspruch 2,
wobei die Rückmeldungserkennungsschaltung eine Rückmeldungswiderstandsschaltung (40) umfasst, die zwischen die Mehrphasen-Abwärtswandler-Schaltung (10) und das Gate geschaltet ist, wobei die Rückmeldungsinformationen eine gemessene Gate-Stromstärke (I_{g}) der Leistungsvorrichtung (200) umfassen;
wobei die PWM-Steuerungseinheit (20) dafür konfiguriert ist, die Mehrphasen-Abwärtswandler-Schaltung (10) basierend auf dem Spitzenbedarf der Drain-Source-Spannung (V_{DS}) und der gemessenen Gate-Stromstärke (I_{g}) zu modulieren, um die Gate-Stromstärke (I_{G}) während einer Abschaltung der Leistungsvorrichtung (200) zu steuern.

4. Gate-Treiberschaltung nach Anspruch 2,
wobei die Rückmeldungsinformationen eine Spannungsveränderungsrate der Drain-Source-Spannung (dV/dt) der Leistungsvorrichtung (200) umfassen;
wobei die PWM-Steuerungseinheit (20) dafür konfiguriert ist, die Mehrphasen-Abwärtswandler-Schaltung (10) basierend auf einem Steigungsbedarf der Spannungsveränderungsrate der Drain-Source-Spannung (dV/dt) zu modulieren, um die Gate-Spannung (V_{GS}) während einer Abschaltung der Leistungsvorrichtung (200) zu steuern.

5. Gate-Treiberschaltung nach Anspruch 4,
wobei die Rückmeldungserkennungsschaltung eine Rückmeldungswiderstandsschaltung (40) umfasst, die zwischen die Mehrphasen-Abwärtswandler-Schaltung (10) und das Gate (G) geschaltet ist, wobei die Rückmeldungsinformationen eine gemessene Gate-Stromstärke (I_{g}) der Leistungsvorrichtung umfassen;
wobei die PWM-Steuerungseinheit (20) dafür konfiguriert ist, die Mehrphasen-Abwärtswandler-Schaltung (10) basierend auf dem Spitzenbedarf der Drain-Source-Spannung (V_{DS}), des Steigungsbedarfs der Spannungsveränderungsrate der Drain-Source-Spannung (dV/dt) und der gemessenen Gate-Stromstärke (I_{g}) zu modulieren, um die Gate-Stromstärke (I_{G}) während einer Abschaltung der Leistungsvorrichtung (200) zu steuern.

6. Gate-Treiberschaltung nach einem der Ansprüche 2 bis 5,
wobei die Schaltung (30) zum Erkennen der Spannung der Leistungsvorrichtung einen Abtastwiderstand (Rₛₑₙ) und mindestens eine Abtastkapazität (C₁-Cₙ) umfasst, wobei der Abtastwiderstand (Rₛₑₙ) und die mindestens eine Abtastkapazität (C₁-Cₙ) parallel geschaltet sind, wobei die Drain-Source-Spannung (V_{DS})und die Spannungsveränderungsrate der Drain-Source-Spannung (dV/dt) basierend auf einem Spannungsabfall an einem Schaltungsknoten zwischen dem Abtastwiderstand (Rₛₑₙ) und der mindestens einen Abtastkapazität (C₁-Cₙ) erkannt werden.

7. Gate-Treiberschaltung nach einem der vorhergehenden Ansprüche,
wobei die Rückmeldungserkennungsschaltung eine Schaltung (50) zum Erkennen der Stromstärke der Leistungsvorrichtung umfasst, die zwischen die Leistungsvorrichtung (200) und die PWM-Steuerungseinheit (20) geschaltet ist, wobei die Rückmeldungsinformationen eine Drain-Source-Stromstärke (I_{DS}) der Leistungsvorrichtung (200) umfassen;
wobei die PWM-Steuerungseinheit (20) dafür konfiguriert ist, die Mehrphasen-Abwärtswandler-Schaltung (10) basierend auf einem Spitzenbedarf der Drain-Source-Stromstärke (I_{DS}) zu modulieren, um die Gate-Spannung (V_{GS}) während einer Inbetriebnahme der Leistungsvorrichtung (200) zu steuern.

8. Gate-Treiberschaltung nach Anspruch 7,
wobei die Rückmeldungserkennungsschaltung eine Rückmeldungswiderstandsschaltung (40) umfasst, die zwischen die Mehrphasen-Abwärtswandler-Schaltung (10) und das Gate (G) geschaltet ist, wobei die Rückmeldungsinformationen eine gemessene Gate-Stromstärke (I_{g}) der Leistungsvorrichtung (200) umfassen;
wobei die PWM-Steuerungseinheit (20) dafür konfiguriert ist, die Mehrphasen-Abwärtswandler-Schaltung (10) basierend auf dem Spitzenbedarf der Drain-Source-Stromstärke (I_{DS}) und der gemessenen Gate-Stromstärke (I_{g}) zu modulieren, um die Gate-Stromstärke (I_{G}) während einer Inbetriebnahme der Leistungsvorrichtung (200) zu steuern.

9. Gate-Treiberschaltung nach Anspruch 7,
wobei die Rückmeldungsinformationen eine Stromstärkeveränderungsrate der Drain-Source-Stromstärke (dI/dt) der Leistungsvorrichtung (200) umfassen;
wobei die PWM-Steuerungseinheit (20) dafür konfiguriert ist, die Mehrphasen-Abwärtswandler-Schaltung (10) basierend auf einem Steigungsbedarf der Drain-Source-Stromstärke (I_{DS}) zu modulieren, um die Gate-Spannung (V_{GS}) während einer Inbetriebnahme der Leistungsvorrichtung (200) zu steuern.

10. Gate-Treiberschaltung nach Anspruch 9,
wobei die Rückmeldungserkennungsschaltung eine Rückmeldungswiderstandsschaltung (40) umfasst, die zwischen die Mehrphasen-Abwärtswandler-Schaltung (10) und das Gate (G) geschaltet ist, wobei die Rückmeldungsinformationen eine gemessene Gate-Stromstärke (I_{g}) der Leistungsvorrichtung umfassen;
wobei die PWM-Steuerungseinheit (20) dafür konfiguriert ist, die Mehrphasen-Abwärtswandler-Schaltung (10) basierend auf dem Spitzenbedarf der Drain-Source-Stromstärke (I_{DS}), dem Steigungsbedarf der Drain-Source-Stromstärke (I_{DS}) und der gemessenen der Gate-Stromstärke (I_{g}) zu modulieren, um die Gate-Stromstärke (I_{G}) während der Inbetriebnahme der Leistungsvorrichtung (200) zu steuern.

11. Gate-Treiberschaltung nach einem der Ansprüche 7 bis 10,
wobei die Schaltung (50) zum Erkennen der Stromstärke der Leistungsvorrichtung eine Streuinduktivität (L_{S}) umfasst, die zwischen einer Leistungsquelle (P_{S}) und einer Source (S) der Leistungsvorrichtung (200) angeordnet ist, wobei die Drain-Source-Stromstärke (I_{DS}) und die Stromstärkeveränderungsrate der Drain-Source-Stromstärke (dI/dt) basierend auf einem Spannungsabfall der Streuinduktivität (L_{S}) erkannt wird.

12. Gate-Treiberschaltung nach einem der vorhergehenden Ansprüche,
wobei die Leistungsvorrichtung eine Vorrichtung mit breitem Bandabstand umfasst, insbesondere eine Siliziumkarbid-, SiC-, Leistungsvorrichtung.

13. Verfahren zum Steuern einer Gate-Treiberschaltung für eine Leistungsvorrichtung, wobei die Gate-Treiberschaltung (100) eine Mehrphasen-Abwärtswandler-Schaltung (10) umfasst, wobei die Mehrphasen-Abwärtswandler-Schaltung (10) mehrere Push-Pull-Schaltungen (L1, L2) umfasst und wobei die mehreren Push-Pull-Schaltungen (L1, L2) parallel zueinander geschaltet sind, wobei die Mehrphasen-Abwärtswandler-Schaltung (10) mit einem Gate (G) der Leistungsvorrichtung (200) verbunden ist, um das Gate (G) anzutreiben, eine Pulsweitenmodulation-, PWM-, Steuerungseinheit (20), die mit der Mehrphasen-Abwärtswandler-Schaltung (10) verschaltet ist, mindestens eine Rückmeldungserkennungsschaltung, die zwischen der Leistungsvorrichtung (200) geschaltet ist, die folgenden Schritte umfassend:
Bereitstellen von Rückmeldungsinformationen der Leistungsvorrichtung an die PWM-Steuerungseinheit (20) durch die mindestens eine Rückmeldungserkennungsschaltung;
Modulieren der Mehrphasen-Abwärtswandler-Schaltung (10) durch die PWM-Steuerungseinheit (20) basierend auf den Rückmeldungsinformationen, um eine Gate-Spannung (V_{GS}) oder eine Gate-Stromstärke (I_{G}) der Leistungsvorrichtung (200) zu steuern.

14. Leistungsvorrichtungssystem, eine Leistungsvorrichtung und eine Gate-Treiberschaltung für die Leistungsvorrichtung nach einem der Ansprüche 1 bis 12 umfassend, wobei die Mehrphasen-Abwärtswandler-Schaltung (10) mit dem Gate (G) der Leistungsvorrichtung (200) verschaltet ist, um das Gate (G) anzutreiben.

## Revendications

1. Circuit de pilotage de grille pour un dispositif de puissance, comprenant :
un circuit convertisseur abaisseur de tension entrelacé (10), connecté à une grille (G) du dispositif de puissance (200) afin de piloter la grille (G),
le circuit convertisseur abaisseur de tension entrelacé (10) comprenant une pluralité de circuits push-pull (L1, L2), la pluralité de circuits push-pull (L1, L2) étant connectés en parallèle entre eux ;
une unité de commande par modulation de largeur d'impulsion, PWM, connectée au circuit convertisseur abaisseur de tension entrelacé (10) ;
au moins un circuit de détection de rétroaction, connecté entre le dispositif de puissance (200) et l'unité de commande PWM (20) et configuré pour fournir des informations de rétroaction du dispositif de puissance (200) à l'unité de commande PWM (20) ;
dans lequel l'unité de commande PWM (20) est configurée pour moduler le circuit convertisseur abaisseur de tension entrelacé (10) sur la base des informations de rétroaction afin de commander une tension de grille (V_{GS}) ou un courant de grille (I_{G}) du dispositif de puissance (200).

2. Circuit de pilotage de grille selon la revendication 1,
dans lequel le circuit de détection de rétroaction comprend un circuit de détection de tension de dispositif de puissance (30), connecté entre le dispositif de puissance (200) et l'unité de commande PWM (20), les informations de rétroaction comprenant une tension drain-source (V_{DS}) du dispositif de puissance (200) ;
dans lequel l'unité de commande PWM (20) est configurée pour moduler le circuit convertisseur abaisseur de tension entrelacé (10) sur la base d'une contrainte de crête de la tension drain-source (V_{DS}) afin de commander la tension de grille (V_{GS}) lors la mise hors conduction du dispositif de puissance (200).

3. Circuit de pilotage de grille selon la revendication 2,
dans lequel le circuit de détection de rétroaction comprend un circuit de résistance de rétroaction (40), connecté entre le circuit convertisseur abaisseur de tension entrelacé (10) et la grille, les informations de rétroaction comprenant un courant de grille mesuré (I_{g}) du dispositif de puissance (200) ;
dans lequel l'unité de commande PWM (20) est configurée pour moduler le circuit convertisseur abaisseur de tension entrelacé (10) sur la base de la contrainte de crête de la tension drain-source (V_{DS}) et du courant de grille mesuré (I_{g}) afin de commander le courant de grille (I_{G}) lors de la mise hors conduction du dispositif de puissance (200).

4. Circuit de pilotage de grille selon la revendication 2,
dans lequel les informations de rétroaction comprennent une vitesse de variation de tension de la tension drain-source (dV/dt) du dispositif de puissance (200) ;
dans lequel l'unité de commande PWM (20) est configurée pour moduler le circuit convertisseur abaisseur de tension entrelacé (10) sur la base d'une contrainte de pente de la vitesse de variation de tension de la tension drain-source (dV/dt) afin de commander la tension de grille (V_{GS}) lors la mise hors conduction du dispositif de puissance (200).

5. Circuit de pilotage de grille selon la revendication 4,
dans lequel le circuit de détection de rétroaction comprend un circuit de résistance de rétroaction (40), connecté entre le circuit convertisseur abaisseur de tension entrelacé (10) et la grille (G), les informations de rétroaction comprenant un courant de grille mesuré (I_{g}) du dispositif de puissance ;
dans lequel l'unité de commande PWM (20) est configurée pour moduler le circuit convertisseur abaisseur de tension entrelacé (10) sur la base de la contrainte de crête de la tension drain-source (V_{DS}), de la contrainte de pente de la vitesse de variation de tension de la tension drain-source (dV/dt) et du courant de grille mesuré (I_{g}) afin de commander le courant de grille (I_{G}) lors de la mise hors conduction du dispositif de puissance (200).

6. Circuit de pilotage de grille selon l'une quelconque des revendications 2 à 5,
dans lequel le circuit de détection de tension de dispositif de puissance (30) comprend une résistance de détection (Rₛₑₙ) et au moins une capacité de détection (C₁-Cₙ), la résistance de détection (Rₛₑₙ) et l'au moins une capacité de détection (C₁-Cₙ) étant connectées en parallèle, la tension drain-source (V_{DS}) et la vitesse de variation de tension de la tension drain-source (dV/dt) étant détectées sur la base d'une chute de tension au niveau d'un nœud de circuit entre la résistance de détection (Rₛₑₙ) et l'au moins une capacité de détection (C₁-Cₙ).

7. Circuit de pilotage de grille selon l'une quelconque des revendications précédentes,
dans lequel le circuit de détection de rétroaction comprend un circuit de détection de courant de dispositif de puissance (50), connecté entre le dispositif de puissance (200) et l'unité de commande PWM (20), les informations de rétroaction comprenant un courant drain-source (I_{DS}) du dispositif de puissance (200) ;
dans lequel l'unité de commande PWM (20) est configurée pour moduler le circuit convertisseur abaisseur de tension entrelacé (10) sur la base d'une contrainte de crête du courant drain-source (I_{DS}) afin de commander la tension de grille (V_{GS}) lors la mise en conduction du dispositif de puissance (200).

8. Circuit de pilotage de grille selon la revendication 7,
dans lequel le circuit de détection de rétroaction comprend un circuit de résistance de rétroaction (40), connecté entre le circuit convertisseur abaisseur de tension entrelacé (10) et la grille (G), les informations de rétroaction comprenant un courant de grille mesuré (I_{g}) du dispositif de puissance (200) ;
dans lequel l'unité de commande PWM (20) est configurée pour moduler le circuit convertisseur abaisseur de tension entrelacé (10) sur la base de la contrainte de crête du courant drain-source (I_{DS}) et du courant de grille mesuré (I_{g}) afin de commander le courant de grille (I_{G}) lors de la mise en conduction du dispositif de puissance (200).

9. Circuit de pilotage de grille selon la revendication 7,
dans lequel les informations de rétroaction comprennent une vitesse de variation de courant du courant drain-source (dI/dt) du dispositif de puissance (200) ;
dans lequel l'unité de commande PWM (20) est configurée pour moduler le circuit convertisseur abaisseur de tension entrelacé (10) sur la base d'une contrainte de pente du courant drain-source (I_{DS}) afin de commander la tension de grille (V_{GS}) lors la mise en conduction du dispositif de puissance (200).

10. Circuit de pilotage de grille selon la revendication 9,
dans lequel le circuit de détection de rétroaction comprend un circuit de résistance de rétroaction (40), connecté entre le circuit convertisseur abaisseur de tension entrelacé (10) et la grille (G), les informations de rétroaction comprenant un courant de grille mesuré (I_{g}) du dispositif de puissance ;
dans lequel l'unité de commande PWM (20) est configurée pour moduler le circuit convertisseur abaisseur de tension entrelacé (10) sur la base de la contrainte de crête du courant drain-source (I_{DS}), de la contrainte de pente du courant drain-source (I_{DS}) et du courant de grille mesuré (I_{g}) afin de commander le courant de grille (I_{G}) lors de la mise en conduction du dispositif de puissance (200).

11. Circuit de pilotage de grille selon l'une quelconque des revendications 7 à 10,
dans lequel le circuit de détection de courant de dispositif de puissance (50) comprend une inductance parasite (L_{S}), disposée entre une source d'alimentation (P_{S}) et une source (S) du dispositif de puissance (200), le courant drain-source (I_{DS}) et la vitesse de variation de courant du courant drain-source (dI/dt) étant détectés sur la base d'une chute de tension aux bornes de l'inductance parasite (L_{S}).

12. Circuit de pilotage de grille selon l'une quelconque des revendications précédentes,
dans lequel le dispositif de puissance comprend un dispositif à large bande interdite, en particulier un dispositif de puissance en carbure de silicium, SiC.

13. Procédé de commande d'un circuit de pilotage de grille pour un dispositif de puissance, le circuit de pilotage de grille (100) comprenant un circuit convertisseur abaisseur de tension entrelacé (10), le circuit convertisseur abaisseur de tension entrelacé (10) comprenant une pluralité de circuits push-pull (L1, L2), et la pluralité de circuits push-pull (L1, L2) étant connectés en parallèle entre eux, le circuit convertisseur abaisseur de tension entrelacé (10) étant connecté à une grille (G) du dispositif de puissance (200) afin de piloter la grille (G), une unité de commande par modulation de largeur d'impulsion, PWM, (20), connectée au circuit convertisseur abaisseur de tension entrelacé (10), au moins un circuit de détection de rétroaction, connecté entre le dispositif de puissance (200), comprenant les étapes suivantes :
fourniture, par l'au moins un circuit de détection de rétroaction, d'informations de rétroaction du dispositif de puissance à l'unité de commande PWM (20) ;
modulation, par l'unité de commande PWM (20), du circuit convertisseur abaisseur de tension entrelacé (10) sur la base des informations de rétroaction afin de commander une tension de grille (V_{GS}) ou un courant de grille (I_{G}) du dispositif de puissance (200).

14. Système de dispositif de puissance comprenant un dispositif de puissance et un circuit de pilotage de grille pour le dispositif de puissance selon l'une quelconque des revendications 1 à 12, le circuit convertisseur abaisseur de tension entrelacé (10) étant connecté à la grille (G) du dispositif de puissance (200) afin de piloter la grille (G).
